# EUROPÄISCHE PATENTSCHRIFT

(11) **EP 3 015 992 B1**
(45) Veröffentlichungstag und Bekanntmachung des Hinweises auf die Patenterteilung: **22.03.2017**
(21) Anmeldenummer: 15193579.8
(22) Anmeldetag: 09.11.2015
(51) Int. Cl.: G06F 13/12, G06F 15/78, G06F 9/44

(54) **VERFAHREN ZUR VERWALTUNG PRIORISIERTER EINGANGSDATEN**
METHOD FOR MANAGING PRIORITIZED INPUT DATA
PROCEDE DE GESTION DE DONNEES D'ENTREE PRIORITAIRES

(30) Priorität: 11.05.2015 DE 102015107299; 11.05.2015 DE 102015107296
(43) Veröffentlichungstag der Anmeldung: 04.05.2016
(73) Patentinhaber: dSPACE digital signal processing and control engineering GmbH, 33102 Paderborn (DE)
(72) Erfinder: Klemm, Matthias, 33102 Paderborn (DE); Schmitz, Matthias, 33102 Paderborn (DE); Sauer, Jochen, 33034 Brakel (DE); Leinfellner, Robert, 33098 Paderborn (DE); Brehm, Thorsten, 33102 Paderborn (DE); Polnau, Robert, 33098 Paderborn (DE)

(56) Entgegenhaltungen:
- EP-A1- 2 799 983
- US-A1- 2005 066 093
- US-A1- 2010 030 509
- RAMONA DUELKS ET AL: "A Real-Time Test and Simulation Environment Based on Standard FPGA Hardware", TESTING: ACADEMIC AND INDUSTRIAL CONFERENCE - PRACTICE AND RESEARCH TECHNIQUES, 2009. TAIC PART '09, IEEE, PISCATAWAY, NJ, USA, 4. September 2009 (2009-09-04), Seiten 197-204, XP031611115, ISBN: 978-0-7695-3820-4
- "Auf zu schnelleren Zeiten", , 1. Juni 2012 (2012-06-01), XP055124881, Gefunden im Internet: URL:http://www.dspace.com/shared/data/pdf/ 2012/Magazin_42_45_Schnelle_Zeiten_D.pdf [gefunden am 2014-06-24]
- "Wenn sich Prozessor und FPGA ergänzen", , 1. Mai 2011 (2011-05-01), XP055124886, Gefunden im Internet: URL:http://www.dspace.com/shared/data/pdf/ 2011/503_dSpace_Ek_auto_2011-05_lowres_pdf .pdf [gefunden am 2014-06-24]

## Beschreibung

Gegenstände der Erfindung sind ein Verfahren zur Verwaltung priorisierter Eingangsdaten gemäß dem Oberbegriff des Patentanspruchs 1 und eine Schnittstelleneinheit gemäß dem Oberbegriff des Patentanspruchs 9.

Viele Computersysteme weisen Schnittstelleneinheiten für den Datenaustausch zwischen einem Hauptprozessor und peripheren Geräten auf. Eine derartige Schnittstelleneinheit kann beispielsweise als steckbare I/O-Karte ausgestaltet sein. Viele Schnittstelleneinheiten sind mit eigenen Prozessoren zur Aufbereitung ein- und auslaufender Daten ausgestattet, wobei es einige Schnittstelleneinheiten ermöglichen, die Programmierung des auf der Schnittstelleneinheit hinterlegten Prozessors flexibel den Anforderungen des durch den Hauptprozessor abgearbeiteten Computerprogramms anzupassen.

Wenn das Computersystem vorgesehen ist, das durch den Hauptprozessor abgearbeitete Programm in harter Echtzeit abzuarbeiten, dann müssen die auf dem Computersystem ablaufenden Prozesse, insbesondere auch die durch die auf der Schnittstelleneinheit hinterlegten Prozessoren abgearbeiteten Prozesse, innerhalb eines vordefinierten Zeitraums garantiert abgeschlossen werden. Ein Beispiel für derartige Systeme sind Testsysteme für elektronische Steuergeräte.

Prinzipiell bedeutet Datenverarbeitung in harter Echtzeit, die Daten hinreichend schnell zu verarbeiten, um ihre Verarbeitung innerhalb eines vorgegebenen Zeitraums sicherzustellen. Grundsätzlich wird in diesem Fall eine effektive Verarbeitung der Daten angestrebt. Aus dem Stand der Technik ist die Priorisierung der von einer Peripherie zugelieferten Eingangsdaten bekannt. Besonders zeitkritische Eingangsdaten werden dabei mit einer höheren Priorität versehen als weniger zeitkritische Eingangsdaten, und höher priorisierte Eingangsdaten werden bevorzugt weitergeleitet und verarbeitet. Aus dem Stand der Technik ist auch bekannt, die den Eingangsdaten zugeordneten Prioritäten auf der Schnittstelleneinheit zu hinterlegen und die Schnittstelleneinheit die Eingangsdaten selbständig priorisieren zu lassen. Die Patentanmeldung US 2003 0137979 A1 beschreibt einen Switch, der ausgestaltet ist, in Echtzeit zu verarbeitende Daten, bspw. für Video-Streaming, zu erkennen und bevorzugt weiterzuleiten. Die Patentanmeldung WO 1996 041272 A1 beschreibt einen Bus-Arbiter für den Datenaustausch zwischen einem Prozessor und einer Peripherie. Periphere Geräte, deren Eingangsdaten in Echtzeit verarbeitet werden müssen, können mittels eines speziellen Signals die bevorzugte Weiterleitung ihrer Eingangsdaten durch den Bus-Arbiter bewirken. Das von der dSPACE GmbH angebotene DS2671 Bus Board ist eine Schnittstelleneinheit mit einem einzigen Prozessor, wobei auf dem Prozessor Prioritäten für durch einen Hauptprozessor abzuarbeitende Tasks hinterlegbar sind, wobei Eingangsdaten für hoch priorisierte Tasks bevorzugt weitergeleitet werden.

Vor diesem Hintergrund ist es Aufgabe der Erfindung, eine den Stand der Technik erweiternde Schnittstelleneinheit und ein den Stand der Technik erweiterndes Verfahren zur hinreichend schnellen und jitterarmen Weiterleitung von Eingangsdaten in harter Echtzeit zu beschreiben. Die Aufgabe wird durch ein Verfahren mit den Merkmalen des Patentanspruchs 1 und durch eine Schnittstelleneinheit mit den Merkmalen des Patentanspruchs 11 gelöst. Vorteilhafte Ausgestaltungen der Erfindung sind Gegenstände von abhängigen Ansprüchen.

Im Rahmen der nachfolgenden Beschreibung der Erfindung ist der Ausdruck "oder" im logischen Sinne nicht als ein Exklusives Oder zu verstehen. Ein Ausdruck "A oder B" schließt demnach den Ausdruck "A und B" mit ein. Unter einem Zugang zu einer Resource des Computersystems ist die Möglichkeit zu verstehen, die Resource bestimmungsgemäß zu nutzen.

Gegenstand der Erfindung ist demnach ein Verfahren zur Verwaltung priorisierter Eingangsdaten in einem Computersystem mit einem ersten Prozessor, einer Schnittstelleneinheit und einer ersten Datenverbindung zwischen dem ersten Prozessor und der Schnittstelleneinheit, wobei die Schnittstelleneinheit einen ersten Schnittstellenprozessor und einen zweiten Schnittstellenprozessor aufweist und eingerichtet ist, um in einer Anzahl von Eingangsdatenkanälen der Schnittstelleneinheit Eingangsdaten von einer Peripherie aufzunehmen und die Eingangsdaten über die erste Datenverbindung an den ersten Prozessor weiterzuleiten. Weiterhin wird eine Peripherie des Computersystems eingerichtet, um mittels einer zweiten Datenverbindung Eingangsdaten in der Anzahl von Eingangsdatenkanälen zu hinterlegen. Auf dem Computersystem wird ein Computerprogramm hinterlegt, eine erste Task und eine zweite Task des Computerprogramms werden eingerichtet, einen durch die Eingangsdaten definierten Wert einzulesen, um einer Variablen des Computerprogramms einen Wert zuzuweisen, und der erste Prozessor wird programmiert, um das Computerprogramm abzuarbeiten.

Die Schnittstelleneinheit weist eine erste Zugriffsverwaltungseinheit auf, die ausgestaltet ist, den Zugang des ersten Schnittstellenprozessors und des zweiten Schnittstellenprozessors zu den in den Eingangsdatenkanälen hinterlegten Eingangsdaten zu kontrollieren, und der erste Schnittstellenprozessor und der zweite Schnittstellenprozessor werden jeweils eingerichtet, eine Anfrage auf Bereitstellung der in der Anzahl von Eingangsdatenkanälen hinterlegten Eingangsdaten an die erste Zugriffsverwaltungseinheit zu senden und die Eingangsdaten an den ersten Prozessor weiterzuleiten oder die Eingangsdaten zu verarbeiten und die verarbeiteten Eingangsdaten an den ersten Prozessor weiterzuleiten.

Der ersten Task wird eine erste Priorität und der zweiten Task eine zweite Priorität zugewiesen, der erste Schnittstellenprozessor wird eingerichtet, Eingangsdaten an die erste Task weiterzuleiten oder Eingangsdaten zu verarbeiten und die verarbeiteten Eingangsdaten an die erste Task weiterzuleiten, und der zweite Schnittstellenprozessor wird eingerichtet, Eingangsdaten an die zweite Task weiterzuleiten oder Eingangsdaten zu verarbeiten und die verarbeiteten Eingangsdaten an die zweite Task weiterzuleiten.

Das erfindungsgemäße Verfahren sieht vor, die erste Priorität und die zweite Priorität auf der ersten Zugriffsverwaltungseinheit zu hinterlegen, wobei die erste Zugriffsverwaltungseinheit eingerichtet ist, während der Abarbeitung des Computerprogramms durch den ersten Prozessor die in der Anzahl von Eingangsdatenkanälen hinterlegten Eingangsdaten dem ersten Schnittstellenprozessor und dem zweiten Schnittstellenprozessor auf Anfrage bereitzustellen oder nicht bereitzustellen und die Eingangsdaten zuerst dem ersten Schnittstellenprozessor bereitzustellen, wenn sowohl vom ersten Schnittstellenprozessor als auch vom zweiten Schnittstellenprozessor eine Anfrage auf Bereitstellung der in der Anzahl von Eingangsdatenkanälen hinterlegten Eingangsdaten vorliegt und die erste Priorität höher als die zweite Priorität ist.

Demnach ist also einzelnen Tasks des Computerprogramms eine Priorität zugeordnet, der erste Schnittstellenprozessor und der zweite Schnittstellenprozessor werden jeweils einer Task zugeordnet, derart, dass die durch den ersten Schnittstellenprozessor weitergeleiteten Eingangsdaten durch die erste Task ausgelesen werden und die die durch den zweiten Schnittstellenprozessor weitergeleiteten Eingangsdaten durch die zweite Task ausgelesen werden, und die den einzelnen Tasks zugeordneten Prioritäten werden an die den einzelnen Tasks jeweils zugeordneten Schnittstellenprozessoren vererbt, d.h. auf der Schnittstelleneinheit hinterlegt und den der jeweiligen Task zugeordneten Schnittstellenprozessoren zugeordnet.

Eine derartige Vererbung der Priorität einer Task an einen ihr zugeordneten Schnittstellenprozessor ist gleichbedeutend mit einer Priorisierung der durch die Task eingelesenen Eingangsdaten. Die Priorität einer Task ist in technischer Hinsicht eine numerische Größe, anhand derer das Computersystem, speziell die Schnittstelleneinheit, entscheidet, welche Tasks bevorzugt Zugriff auf ihre Eingangsdaten erhalten. Es ist für die Erfindung unbedeutend, ob eine Priorität formal einer Task, einem Schnittstellenprozessor oder den durch den Schnittstellenprozessor weitergeleiteten Eingangsdaten zugeordnet wird.

Unter einem Schnittstellenprozessor ist im Rahmen der Erfindung ein auf der Schnittstelleneinheit hinterlegter Prozessor zu verstehen, der einrichtbar und vorgesehen ist, um von einer Peripherie erzeugte Eingangsdaten an den ersten Prozessor weiterzuleiten, d.h. um ein in einem Eingangsdatenkanal hinterlegtes Eingangsdatum auszulesen und eine Kopie des Eingangsdatums an einer durch den ersten Prozessor auslesbaren Speicheradresse zu hinterlegen oder eine Hinterlegung einer Kopie des Eingangsdatums an einer durch den ersten Prozessor auslesbaren Speicheradresse zu veranlassen, oder um ein in einem Eingangsdatenkanal hinterlegtes Eingangsdatum auszulesen, zu verarbeiten und ein Ergebnis der Verarbeitung des Eingangsdatums an einer durch den ersten Prozessor auslesbaren Speicheradresse zu hinterlegen oder eine Hinterlegung eines Ergebnisses der Verarbeitung des Eingangsdatum an einer durch den ersten Prozessor auslesbaren Speicheradresse zu veranlassen. Darüber hinaus impliziert der Begriff Schnittstellenprozessor keine technischen Spezifikationen.

Eine wichtige Abgrenzung der Erfindung zum Stand der Technik ist, dass auf der Schnittstelleneinheit eine Mehrzahl von Schnittstellenprozessoren hinterlegt ist und die auf der Schnittstelleneinheit hinterlegten Prioritäten sich auf die Schnittstellenprozessoren beziehen. Hoch priorisierte Schnittstellenprozessoren erhalten bevorzugten Zugriff auf die Eingangsdatenkanäle und die dort hinterlegten Eingangsdaten. Ein Vorteil der Erfindung ist, dass sie eine parallele Verarbeitung und Weiterleitung priorisierter Eingangsdaten ermöglicht. Durch die Verwendung mindestens zweier Schnittstellenprozessoren können unterschiedliche Programmroutinen zur Weiterleitung und Verarbeitung von Eingangsdaten, beispielsweise für unterschiedliche Tasks des Computerprogramms, parallel und voneinander unabhängig auf der Schnittstelleneinheit abgearbeitet werden. Insbesondere ist dadurch, was für Datenverarbeitung in Echtzeit von großer Bedeutung ist, die Bearbeitungszeit der Programmroutinen auf der Schnittstelleneinheit vorhersagbar, weil Programmroutinen nicht zugunsten höher priorisierter Programmroutinen unterbrochen werden. Gleichzeitig sind die unterschiedlichen Programmroutinen auf der Schnittstelleneinheit hinsichtlich ihres Zugriffs auf die Eingangsdatenkanäle priorisierbar, weil der Zugriff auf die Eingangsdatenkanäle von einer den Schnittstellenprozessoren übergeordneten Instanz, der ersten Zugriffsverwaltungseinheit, verwaltet wird.

Die Schnittstelleneinheit ist in einer Ausgestaltung als austauschbare Schnittstelleneinheit ausgestaltet, insbesondere als steckbare I/O-Karte. Unter einer austauschbaren Schnittstelleneinheit ist erfindungsgemäß zu verstehen, dass die Schnittstelleneinheit als modulares Bauteil eines Computersystems ausgestaltet ist und die Schnittstelleneinheit vorgesehen ist, um durch einen Anwender des Computersystems aus dem Computersystem entfernt und gegen eine andere modulare Komponente ausgetauscht zu werden. Eine steckbare I/O-Karte bezeichnet im Zusammenhang der Erfindung eine als steckbare Leiterplatte ausgestaltete Schnittstelleneinheit, die vorgesehen ist, um in einen Schacht eines modularen Computersystems eingeführt zu werden und Eingangsdaten von einer Peripherie des Computersystems an einen ersten Prozessor des Computersystems weiterzuleiten.

Bevorzugt ist das Computersystem eingerichtet, um das Computerprogramm in harter Echtzeit abzuarbeiten. Besonders bevorzugt ist das Computersystem als Hardware-in-the-Loop-Simulator (HIL) oder als Rapid-Control-Prototyping-Plattform ausgestaltet.

Unter einem Hardware-in-the-Loop-Simulator ist im Zusammenhang der Erfindung insbesondere ein Computersystem zu verstehen, das eingerichtet und vorgesehen ist, um mit den Dateneingängen und Datenausgängen eines eigebetteten Systems, beispielsweise eines elektronischen Steuergeräts oder einer mechatronischen Komponente, verbunden zu werden, und das weiterhin eingerichtet ist, insbesondere auch hinsichtlich der in dem Computersystem verbauten Hardware eingerichtet ist, um die reale Umgebung des eingebetteten Systems in harter Echtzeit zu simulieren.

Unter einem Rapid-Control-Prototyping-System ist im Zusammenhang der Erfindung insbesondere ein tragbares Computersystem zu verstehen, das eingerichtet und vorgesehen ist, in ein Netzwerk elektronischer Steuergeräte eingebunden zu werden, beispielsweise in einem Automobil, in dem Netzwerk vorübergehend die Aufgabe eines elektronischen Steuergeräts zu übernehmen und in harter Echtzeit Daten mit elektronischen Steuergeräten auszutauschen, Daten von Sensoren einzulesen und Aktoren anzusteuern.

In einer bevorzugten Ausgestaltung weist die Schnittstelleneinheit noch eine zweite Zugriffsverwaltungseinheit auf, wobei der erste und der zweite Schnittstellenprozessor eingerichtet werden, eine Anfrage auf Zugang zu der ersten Datenverbindung an die zweite Zugriffsverwaltungseinheit zu senden, wobei die zweite Zugriffsverwaltungseinheit eingerichtet ist, um dem ersten Schnittstellenprozessor und dem zweiten Schnittstellenprozessor während der Abarbeitung des Computerprogramms durch den ersten Prozessor den Zugang zu der ersten Datenverbindung auf Anfrage zu erteilen oder nicht zu erteilen und den Zugang zu der ersten Datenverbindung zuerst dem ersten Schnittstellenprozessor zu erteilen, wenn sowohl vom ersten Schnittstellenprozessor als auch vom zweiten Schnittstellenprozessor eine Anfrage auf Zugang zu der ersten Datenverbindung vorliegt und die erste Priorität höher als die zweite Priorität ist.

Bevorzugt wird vor Beginn der Abarbeitung des Computerprogramms durch den ersten Prozessor eine Konfigurationsphase des Computersystems gestartet, wobei das Computersystem, insbesondere der erste Prozessor, während der Konfigurationsphase den ersten Prozessor und den zweiten Prozessor einrichtet. Insbesondere werden während der Konfigurationsphase die erste Priorität und die zweite Priorität, auf der ersten Zugriffsverwaltungseinheit hinterlegt. Sofern eine zweite Zugriffsverwaltungseinheit hinterlegt ist, werden die erste Priorität und die zweite Priorität während der Konfigurationsphase auf der ersten Zugriffsverwaltungseinheit und auf der zweiten Zugriffsverwaltungseinheit hinterlegt.

In einer weiteren bevorzugten Ausgestaltung weist die Schnittstelleneinheit mehr als zwei Schnittstellenprozessoren auf, also neben dem ersten Schnittstellenprozessor und dem zweiten Schnittstellenprozessor zumindest noch einen dritten Schnittstellenprozessor, und jeder Schnittstellenprozessor ist entweder einer Task des Computerprogramms eindeutig zugeordnet oder keiner Task des Computerprogramms zugeordnet.

Erfindungsgemäß arbeiten die Schnittstellenprozessoren Programmroutinen ab, um Eingangsdaten unverändert oder in verarbeiteter Form an den ersten Prozessor weiterzuleiten. Unter einer Zuordnung eines Schnittstellenprozessors zu einer Task ist zu verstehen, dass die von dem Schnittstellenprozessor weitergeleiteten Eingangsdaten von der Task eingelesen werden. Ein Schnittstellenprozessor ist einer Task eindeutig zugeordnet, wenn die von dem Schnittstellenprozessor weitergeleiteten Eingangsdaten ausschließlich von der Task eingelesen werden. Jeder Schnittstellenprozessor ist einrichtbar, um eine Anfrage auf Bereitstellung der in der Anzahl von Eingangsdatenkanälen hinterlegten Eingangsdaten zu stellen, und für jeden einer Task zugeordneten Schnittstellenprozessor wird eine Priorität hinterlegt.

Weiterhin bevorzugt weist die Schnittstelleneinheit mindestens einen Ausgangsdatenkanal auf, wobei der Ausgangsdatenkanal eingerichtet und vorgesehen ist, um Ausgangsdaten in dem Ausgangsdatenkanal zu hinterlegen und die im Ausgangsdatenkanal hinterlegten Ausgangsdaten durch eine Peripherie des Computersystems auslesen zu lassen, und ein dritter Schnittstellenprozessor wird eingerichtet, um von dem Computerprogramm erzeugte Ausgangsdaten in dem Ausgangsdatenkanal zu hinterlegen. Zwischen dem ersten Prozessor und dem dritten Schnittstellenprozessor ist eine die zweite Zugriffsverwaltungseinheit umgehende erste direkte Datenverbindung eingerichtet, d.h. der dritte Schnittstellenprozessor ist ausgestaltet, die Ausgangsdaten auszulesen und in dem Datenausgangskanal zu hinterlegen, ohne dafür eine Anfrage auf Zugang zu der ersten Datenverbindung an die zweite Zugriffsverwaltungseinheit zu senden.

In einer Ausgestaltung der Erfindung ist außerdem zwischen einem Schnittstellenprozessor und einem Eingangsdatenkanal oder einem Ausgangsdatenkanal eine die erste Zugriffsverwaltungseinheit umgehende zweite direkte Datenverbindung eingerichtet. Das bedeutet, ein Schnittstellenprozessor, beispielsweise der Schnittstellenprozessor mit der höchsten Priorität, ist eingerichtet, um Eingangsdaten aus einem Eingangsdatenkanal einzulesen, ohne dafür eine Anfrage auf Bereitstellung der in den Eingangsdatenkanälen hinterlegten Eingangsdaten an die erste Zugriffsverwaltungseinheit zu senden, oder der Schnittstellenprozessor mit der höchsten Priorität ist eingerichtet, um Ausgangsdaten in einem Ausgangsdatenkanal zu hinterlegen, ohne dafür eine Anfrage auf Zugang zu dem Ausgangsdatenkanal an die erste Zugriffsverwaltungseinheit zu senden.

Bevorzugt ist auf der Schnittstelleneinheit ein FPGA verbaut, und die Schnittstellenprozessoren sind als Softcore-Prozessoren auf dem FPGA hinterlegt oder werden, insbesondere während der Konfigurationsphase, als Softcore-Prozessoren auf dem FPGA hinterlegt. Die Programmierung eines Softcore-Prozessors auf einem FPGA ist dem Fachmann aus dem Stand der Technik bekannt. Ein Fachmann versteht unter einem Softcore-Prozessor einen in die logische Schaltung eines FPGAs programmierten Prozessor.

Ein weiterer Gegenstand der Erfindung ist eine Schnittstelleneinheit für den Datenaustausch zwischen einem ersten Prozessor eines Computersystems und einer Peripherie des Computersystems. Die Schnittstelleneinheit weist einen Datenanschluss für eine Anbindung der Schnittstelleneinheit an eine erste Datenverbindung des Computersystems auf, wobei mittels der ersten Datenverbindung Daten von der Schnittstelleneinheit zu dem ersten Prozessor übertragbar sind. Die Schnittstelleneinheit weist weiterhin eine Anzahl von Eingangsdatenkanälen zur Aufnahme von Eingangsdaten von der Peripherie auf, wobei die Eingangsdaten von der Peripherie mittels einer zweiten Datenverbindung in der Anzahl von Eingangsdatenkanälen hinterlegbar sind. Die Schnittstelleneinheit weist eine erste Zugriffsverwaltungseinheit auf, und die erste Zugriffsverwaltungseinheit ist eingerichtet, um von einem auf der Schnittstelleneinheit hinterlegten ersten Schnittstellenprozessor, der für die Weiterleitung von Eingangsdaten an eine erste Task eines von dem ersten Prozessor (CN) abgearbeiteten Computerprogramms oder für die Verarbeitung von Eingangsdaten und die Weiterleitung der verarbeiteten Eingangsdaten an eine erste Task des Computerprogramms eingerichtet ist, und von einem auf der Schnittstelleneinheit hinterlegten zweiten Schnittstellenprozessor, der für die Weiterleitung von Eingangsdaten an eine zweite Task des Computerprogramms oder für die Verarbeitung von Eingangsdaten und die Weiterleitung der verarbeiteten Eingangsdaten an eine zweite Task des Computersystems eingerichtet ist, eine Anfrage auf Bereitstellung der in der Anzahl an Eingangsdatenkanälen hinterlegten Eingangsdaten zu empfangen und dem ersten Schnittstellenprozessor und dem zweiten Schnittstellenprozessor die in der Anzahl an Eingangsdatenkanälen hinterlegten Eingangsdaten auf Anfrage bereitzustellen oder nicht bereitzustellen.

Auf der ersten Zugriffsverwaltungseinheit sind eine der ersten Task zugewiesene erste Priorität und eine der zweiten Task zugewiesene zweite Priorität hinterlegbar, d.h. die erste Zugriffsverwaltungseinheit ist eingerichtet, um Werte für eine erste Priorität und für eine zweite Priorität aufzunehmen und zu speichern. Weiterhin ist die erste Zugriffsverwaltungseinheit eingerichtet, um die in der Anzahl von Eingangsdatenkanälen hinterlegten Eingangsdaten zuerst dem ersten Schnittstellenprozessor bereitzustellen, wenn sowohl vom ersten Schnittstellenprozessor als auch vom zweiten Schnittstellenprozessor eine Anfrage auf Bereitstellung der in der Anzahl von Eingangsdatenkanälen hinterlegten Eingangsdaten vorliegt und die erste Priorität höher als die zweite Priorität ist.

Bevorzugt weist die Schnittstelleneinheit außerdem eine zweite Zugriffsverwaltungseinheit auf, wobei auf der zweiten Zugriffsverwaltungseinheit die erste Priorität und die zweite Priorität hinterlegbar sind. Dabei ist die zweite Zugriffsverwaltungseinheit eingerichtet, um vom ersten Schnittstellenprozessor und vom zweiten Schnittstellenprozessor eine Anfrage auf Zugang zu der ersten Datenverbindung entgegenzunehmen, den Zugang zu erteilen oder nicht zu erteilen und den Zugang zu der ersten Datenverbindung zuerst dem ersten Schnittstellenprozessor zu erteilen, wenn sowohl vom ersten Schnittstellenprozessor als auch vom zweiten Schnittstellenprozessor eine Anfrage auf Zugang zu der ersten Datenverbindung vorliegt und die erste Priorität höher als die zweite Priorität ist.

In einer bevorzugten Ausgestaltung ist auf der Schnittstelleneinheit ein durch das Computersystem programmierbares FPGA verbaut, wobei das FPGA für die Hinterlegung des ersten Schnittstellenprozessors und des zweiten Schnittstellenprozessors in Form von Softcore-Prozessoren eingerichtet ist. Weiterhin bevorzugt ist die erste Zugriffsverwaltungseinheit eingerichtet, um dem ersten Schnittstellenprozessor und dem zweiten Schnittstellenprozessor die in einem beliebigen Eingangsdatenkanal hinterlegten Eingangsdaten bereitzustellen. Das bedeutet, dass die in einem beliebigen Eingangsdatenkanal der Schnittstelleneinheit hinterlegten Eingangsdaten durch jeden Schnittstellenprozessor auslesbar sind, sofern die erste Zugriffsverwaltungseinheit dem betreffenden Schnittstellenprozessor Zugang zu der Anzahl von Eingangsdatenkanälen erteilt hat.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und vertikalen Erstreckungen sind nicht maßstäblich und weisen, sofern nicht anders angegeben auch keine ableitbaren geometrischen Relationen zueinander auf.

Es zeigen
- Figur 1: ein Computersystem mit einer aus dem Stand der Technik bekannten Schnittstelleneinheit,
- Figur 2: ein Computersystem mit einer ersten bevorzugten Ausführungsform einer erfindungsgemäßen Schnittstelleneinheit und
- Figur 3: ein Computersystem mit einer zweiten bevorzugten Ausführungsform einer erfindungsgemäßen Schnittstelleneinheit.

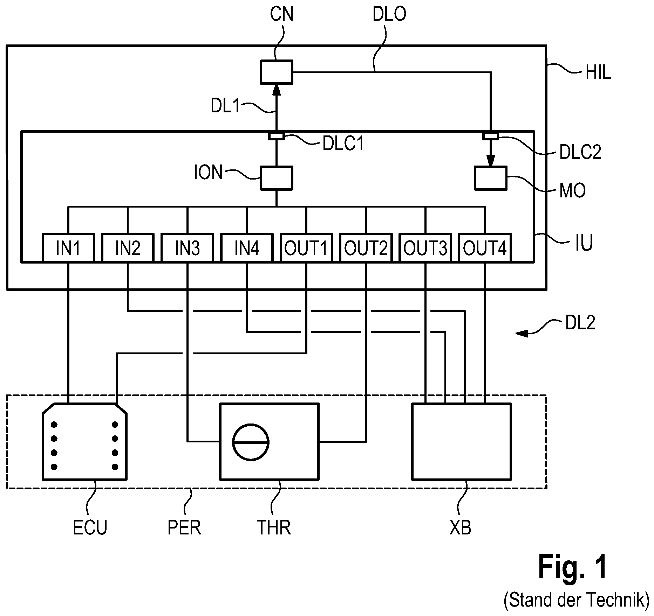

Die Abbildung der Figur 1 skizziert ein als Hardware-in-the-Loop-Simulator ausgestaltetes Computersystem HIL mit einer Schnittstelleneinheit IU, wie es aus dem Stand der Technik bekannt ist. In dem Computersystem ist ein erster Prozessor CN verbaut, eine erste Datenverbindung DL1 ist für die Übertragung von Daten von der Schnittstelleneinheit IU zu dem ersten Prozessor CN eingerichtet und eine Ausgangsdatenverbindung DLO ist für die Übertragung von Daten vom ersten Prozessor CN in einen internen Speicher MO der Schnittstelleneinheit IU eingerichtet. Der interne Speicher MO ist durch den Schnittstellenprozessor ION auslesbar. Die Schnittstelleneinheit IU weist eine Anzahl von vier Eingangsdatenkanälen auf, einen ersten Eingangsdatenkanal IN1, einen zweiten Eingangsdatenkanal IN2, einen dritten Eingangsdatenkanal IN3 und einen vierten Eingangsdatenkanal IN4, und die Schnittstelleneinheit IU weist eine Anzahl von vier Ausgangsdatenkanälen auf, einen ersten Ausgangsdatenkanal OUT1, einen zweiten Ausgangsdatenkanal OUT2, einen dritten Ausgangsdatenkanal OUT3 und einen vierten Ausgangsdatenkanal OUT4. Eine Peripherie PER des Computersystems HIL ist eingerichtet, um mittels einer aus einer Vielzahl von Kabelverbindungen aufgebauten zweiten Datenverbindung DL2 Eingangsdaten in den Eingangsdatenkanälen IN1, ..., IN4 zu hinterlegen und Ausgangsdaten aus den Ausgangsdatenkanälen OUT1, ..., OUT4 auszulesen. In jedem Eingangsdatenkanal IN1, ..., IN4 und in jedem Ausgangsdatenkanal OUT1, ... OUT4 ist ein nicht dargestellter Datenkanalprozessor hinterlegt. Jeder in einem Eingangsdatenkanal IN1, ..., IN4 hinterlegte Datenkanalprozessor ist durch die Peripherie PER beschreibbar, wenn die zweite Datenverbindung DL2 eine dafür eingerichtete Kabelverbindung aufweist, und jeder in einem Ausgangsdatenkanal OUT1, ..., OUT4 hinterlegte Datenkanalprozessor ist durch die Peripherie PER auslesbar, wenn die zweite Datenverbindung DL2 eine dafür eingerichtete Kabelverbindung aufweist.

Die Peripherie PER beinhaltet drei periphere Komponenten: ein elektronisches Steuergerät ECU, eine Echtlast THR und eine Erweiterungsbox XB. Die zweite Datenverbindung DL2 ist als eine Vielzahl von Kabelverbindungen eingerichtet, die zwischen den peripheren Komponenten THR, ECU, XB der Peripherie PER und den Eingangsdatenkanälen IN1, ..., IN4 und den Ausgangsdatenkanälen OUT1, ..., OUT4 der Schnittstelleneinheit IU verlegt sind. Das elektronische Steuergerät ECU ist ein physisches Steuergerät, beispielsweise ein automotives Steuergerät, das in die Simulation eingebunden ist, um die auf dem elektronischen Steuergerät ECU hinterlegte Software auf korrekte Funktion zu überprüfen. Dazu simuliert der erste Prozessor CN mittels eines auf dem ersten Prozessor CN hinterlegten Computerprogramms in harter Echtzeit die Umgebung des elektronischen Steuergerätes, insbesondere weitere elektronische Steuergeräte, Sensoren, Aktoren und Fahrmanöver des simulierten Fahrzeugs, und tauscht dazu mit dem elektronischen Steuergerät ECU Daten aus. Das elektronische Steuergerät ist eingerichtet, um aus dem ersten Ausgangsdatenkanal OUT1 der Schnittstelleneinheit IU durch den ersten Prozessor CN erzeugte Ausgangsdaten einzulesen, und es ist eingerichtet, um in dem ersten Eingangsdatenkanal IN1 durch das elektronische Steuergerät erzeugte Eingangsdaten zur Verwertung durch den ersten Prozessor CN zu hinterlegen, beispielsweise ein Steuersignal für eine durch den ersten Prozessor CN simulierte Komponente.

Die Echtlast THR ist beispielsweise eine Drosselklappe eines Automobils. Da das Computerprogramm nicht eingerichtet ist, eine Drosselklappe zu simulieren, ist die Drosselklappe als physische Komponente in die Simulation eingebunden. Der erste Prozessor CN erzeugt nach den Vorgaben des Computerprogramms ein Steuersignal für einen Aktor der Echtlast THR, und das Steuersignal wird über den zweiten Ausgangsdatenkanal OUT2 der Schnittstelleneinheit IU an den Aktor übertragen. Ein Sensor der Echtlast THR wird über den dritten Eingangsdatenkanal IN3 der Schnittstelleneinheit IU ausgelesen und das ausgelesene Sensorsignal durch den ersten Prozessor CN anhand der Vorgaben des Computerprogramms verwertet.

Die Erweiterungsbox XB enthält weitere, dem ersten Prozessor CN bei der Abarbeitung des Computerprogramms assistierende Computerkomponenten in Form steckbarer Leiterplatten. Die Erweiterungsbox XB ist eingerichtet, um Ausgangsdaten aus dem dritten Ausgangsdatenkanal OUT3 und dem vierten Ausgangsdatenkanal OUT4 einzulesen und Eingangsdaten in dem zweiten Eingangsdatenkanal IN2 und dem vierten Eingangsdatenkanal IN4 zu hinterlegen.

Auf der Schnittstelleneinheit IU ist ein einziger Schnittstellenprozessor ION verbaut. Die Speicheradressen der in den Eingangsdatenkanälen IN1, ..., IN4 hinterlegten Datenkanalprozessoren sind durch den Schnittstellenprozessor ION auslesbar, und die Speicheradressen der in den Ausgangsdatenkanälen OUT1, ..., OUT4 hinterlegten Datenkanalprozessoren sind durch den Schnittstellenprozessor ION beschreibbar. Auf dem Schnittstellenprozessor ION ist eine Vielzahl von Programmfunktionen hinterlegt, um in der Anzahl von Eingangsdatenkanälen IN1, ..., IN4 hinterlegte Eingangsdaten zu verarbeiten und an den ersten Prozessor CN weiterzuleiten, d.h. um ein Eingangsdatum an einer Speicheradresse der in den Eingangsdatenkanälen IN1, ..., IN4 hinterlegten Datenkanalprozessoren einzulesen, das eingelesene Eingangsdatum optional zu verarbeiten und das Eingangsdatum in verarbeiteter Form oder unverändert an eine durch den ersten Prozessor CN auslesbare Speicheradresse zu schreiben oder das Schreiben des Eingangsdatums in verarbeiteter Form oder unverändert an eine durch den ersten Prozessor CN auslesbare Speicheradresse zu veranlassen. Auf dem Schnittstellenprozessor ION ist außerdem eine Vielzahl von Programmfunktionen hinterlegt, um durch den ersten Prozessor CN hinterlegte Ausgangsdaten zu verarbeiten und an die Peripherie PER weiterzuleiten, d.h. um ein durch das Computerprogramm erzeugtes Ausgangsdatum an einer Speicheradresse einzulesen, das eingelesene Ausgangsdatum optional zu verarbeiten und das Ausgangsdatum in verarbeiteter Form oder unverändert an einer Speicheradresse der in den Ausgangsdatenkanälen OUT1, ..., OUT4 hinterlegten Datenkanalprozessoren zu hinterlegen.

Die Schnittstelleneinheit IU ist als steckbare I/O-Karte ausgestaltet und eingerichtet, um durch Einschieben in einen Schacht des Computersystems HIL über einen Eingangsdatenanschluss DLC1 und einen Ausgangsdatenanschluss DLC2 mit dem internen Bus des Computersystems HIL verbunden zu werden, wobei mittels des internen Busses die Datenverbindungen zwischen dem ersten Prozessor CN und der Schnittstelleneinheit IU ausgebildet werden. Mittels des Eingangsdatenanschlusses DLC1 ist die Schnittstelleneinheit mit der ersten Datenverbindung DL1 verbunden, mittels des Ausgangsdatenanschlusses DLC2 mit der Ausgangsdatenverbindung DLO.

Ein Simulationslauf mit dem Computersystem HIL erfolgt derart, dass auf dem Computersystem HIL ein Computerprogramm zur Simulation einer Umgebung des elektronischen Steuergeräts ECU hinterlegt wird und der erste Prozessor CN programmiert wird, um das Computerprogramm abzuarbeiten. Das Computerprogramm beinhaltet eine Vielzahl von Tasks, wobei einige Tasks Daten mit der Peripherie PER austauschen, also von der Peripherie PER zugelieferte Eingangsdaten einlesen und verarbeiten oder Ausgangsdaten an die Peripherie PER senden. Tasks des Computerprogramms, die Daten mit der Peripherie austauschen, werden im Folgenden als I/O-Tasks bezeichnet.

Vor Beginn der Abarbeitung des Computerprogramms wird eine Konfigurationsphase des Computersystems HIL gestartet, um das Computersystem HIL und die Peripherie PER für die Abarbeitung des Computerprogramms einzurichten. Während der Konfigurationsphase wird für jede I/O-Task eine Programmroutine auf dem Schnittstellenprozessor ION eingerichtet, wobei jede der Programmroutinen zumindest ausgestaltet ist, um Eingangsdaten aus einem Eingangsdatenkanal IN1, ..., IN4 einzulesen und an eine durch den ersten Prozessor CN auslesbare Speicheradresse weiterzuleiten oder um von dem ersten Prozessor CN hinterlegte Ausgangsdaten aus dem internen Speicher MO auszulesen und in einen Ausgangsdatenkanal OUT1, ..., OUT4 weiterzuleiten. Jede der Programmroutinen ist zudem optional ausgestaltbar, die eingelesenen Eingangsdaten oder Ausgangsdaten vor der Weiterleitung zu verarbeiten, beispielsweise zu paketieren, zu skalieren, zu verrechnen oder logisch zu verarbeiten.

Jeder I/O-Task wird während der Konfigurationsphase eine Priorität zugeordnet, und die Prioritäten der I/O-Tasks werden während der Konfigurationsphase auf dem Schnittstellenprozessor ION hinterlegt. Der Schnittstellenprozessor ION wird eingerichtet, um die Eingangsdaten oder Ausgangsdaten hoch priorisierter I/O-Tasks bevorzugt zu verarbeiten und weiterzuleiten.

Angesichts des Anspruchs an das Computersystem HIL, das Computerprogramm in harter Echtzeit abzuarbeiten und folglich auch den Datenaustausch mit der Peripherie PER in harter Echtzeit durchzuführen, ist das eben beschriebene Verfahren zur Weiterleitung von Eingangsdaten und Ausgangsdaten mittels einer Schnittstelleneinheit IU wie in der Abbildung der Figur 1 problematisch. Für harte Echtzeit muss die Abarbeitung von Programmroutinen nicht nur hinreichend schnell erfolgen, die für die Abarbeitung benötigte Zeit muss auch mit hoher Genauigkeit vorhersagbar sein, um eine hinreichend schnelle Abarbeitung garantieren zu können. In dem in der Figur 1 gezeigten Aufbau ist es möglich, dass die Abarbeitung einer auf dem Schnittstellenprozessor ION laufenden Programmroutine zugunsten einer anderen Programmroutine, die einer höher priorisierten Task zugeordnet ist, unterbrochen wird. Um trotzdem alle auf dem Schnittstellenprozessor ION ablaufenden Programmroutinen hinreichend schnell abzuarbeiten, kann als Schnittstellenprozessor ION ein schneller Prozessor verwendet werden. Derartige Prozessoren weisen aber unterschiedliche technische Vorkehrungen zur Beschleunigung der Abarbeitung von Programmroutinen auf, die die Vorhersagbarkeit der zur Abarbeitung von Programmroutinen benötigten Zeit zusätzlich verschlechtern, beispielsweise automatische Parallelisierung auf mehrere Prozessorkerne und Caching.

Eine Bauweise für eine Schnittstelleneinheit IU, wie die in der Abbildung der Figur 1 skizzierte, führt demnach bauartbedingt zu unvorhersagbaren Schwankungen der Abarbeitungszeit von Programmroutinen zur Weiterleitung und Verarbeitung von Eingangsdaten und Ausgangsdaten auf der Schnittstelleneinheit in einer für Anforderungen harter Echtzeit problematischen Größenordnung. Dem Fachmann sind derartige Schwankungen als Jitter bekannt. Vor diesem Hintergrund ist es die Aufgabe der Erfindung, eine Schnittstelleneinheit oder ein Verfahren zur hinreichend schnellen und jitterarmen Weiterleitung von Eingangsdaten in harter Echtzeit zu beschreiben.

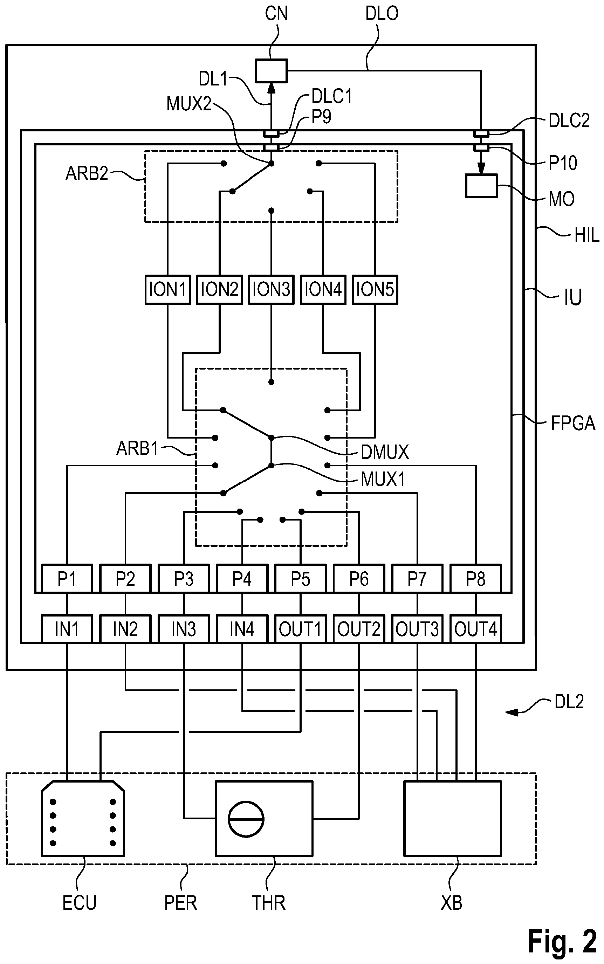

Die Abbildung der Figur 2 zeigt eine erste bevorzugte Ausführungsform der Erfindung. Im Folgenden werden nur die Unterschiede zu der Abbildung der Figur 1 erläutert.

Auf der Schnittstelleneinheit IU ist ein FPGA verbaut, und ein erster Schnittstellenprozessor ION1, ein zweiter Schnittstellenprozessor ION2, ein dritter Schnittstellenprozessor ION3, ein vierter Schnittstellenprozessor ION4 und ein fünfter Schnittstellenprozessor ION5 sind als Softcore-Prozessoren in die logische Schaltung des FPGAs programmiert. Die Schnittstellenprozessoren ION1, ..., ION5 sind als durch den ersten Prozessor CN programmierbare Flow-Control-Prozessoren ausgestaltet. Jeder Schnittstellenprozessor ION1, ..., ION5 weist nur einen Prozessorkern auf und ist eingerichtet, um eine durch den ersten Prozessor CN in den Schnittstellenprozessor ION1, ..., ION5 programmierte Sequenz von Prozessorbefehlen sequentiell abzuarbeiten, wobei die für die Abarbeitung einer Sequenz von Prozessorbefehlen benötigte Zeit sich ausschließlich von der Taktung des Schnittstellenprozessor ION1, ..., ION5 und der Anzahl der in der Sequenz enthaltenen Prozessorbefehle ergibt. Die Schnittstellenprozessoren weisen keine technischen Vorkehrungen zur Beschleunigung der Abarbeitung einer Sequenz von Prozessorbefehlen auf, die eine Verschlechterung der Vorhersagbarkeit der für die Abarbeitung einer Sequenz von Prozessorbefehlen benötigten Zeit bewirken würden. Insbesondere sind die Schnittstellenprozessoren ION1, ..., ION5 ausgestaltet, um bei der Abarbeitung einer Sequenz von Prozessorbefehlen kein Caching anzuwenden. Untersuchungen haben gezeigt, dass es möglich ist, acht derartig einfach ausgestalteter Softcore-Prozessoren in die logische Schaltung eines FPGAs zu programmieren. Jede auf einen Schnittstellenprozessor ION1, ..., ION5 programmierte Sequenz von Prozessorbefehlen stellt eine Programmroutine zur Weiterleitung und optional zur Verarbeitung von Eingangsdaten oder Ausgangsdaten dar.

Das FPGA ist über acht FPGA-Datenanschlüsse P1, ..., P8 mit den vier Eingangsdatenkanälen IN1, ..., IN4 und mit den vier Ausgangsdatenkanälen OUT1, ..., OUT4 der Schnittstelleneinheit IU verbunden, wobei jeder FPGA-Datenanschluss mindestens einen Pin des FPGAs beinhaltet. und ein erster Arbiter ARB1 ist in die logische Schaltung des FPGAs programmiert. Der erste Arbiter ARB1 ist ausgestaltet, um mittels eines ersten Multiplexers MUX1 und eines Demultiplexers DMUX (bezogen auf die Flussrichtung eines Eingangsdatums) eine Datenverbindung zwischen einem beliebigen Schnittstellenprozessor ION1, ..., ION5 und einem beliebigen Eingangsdatenkanal IN1, ..., IN4 oder Ausgangsdatenkanal OUT1, ..., OUT4 einzurichten. Beispielsweise ist in der Abbildung eine Datenverbindung zwischen dem zweiten Schnittstellenprozessor ION2 und dem zweiten Eingangsdatenkanal IN2 eingerichtet, sodass die in dem zweiten Eingangsdatenkanal ION2 hinterlegten Eingangsdaten für den zweiten Schnittstellenprozessor ION2 bereitgestellt sind.

Der erste Arbiter ARB1 weist zudem eine durch den ersten Prozessor CN konfigurierbare erste Steuerlogik (nicht dargestellt) zur Ansteuerung des ersten Multiplexers MUX1 und des Demultiplexers DMUX auf. Die erste Steuerlogik ist eingerichtet, um fünf Prioritäten vom ersten Prozessor CN aufzunehmen und zu speichern: eine erste Priorität für den ersten Schnittstellenprozessor ION1, eine zweite Priorität für den zweiten Schnittstellenprozessor ION2, eine dritte Priorität für den dritten Schnittstellenprozessor ION3, eine vierte Priorität für den vierten Schnittstellenprozessor ION4 und eine fünfte Priorität für den fünften Schnittstellenprozessor ION5. Der erste Arbiter ARB1 ist anhand der ersten Steuerlogiklogik eingerichtet, um von einem beliebigen Schnittstellenprozessor ION1, ..., ION5 eine Anfrage auf Einrichtung einer Datenverbindung zu einem beliebigen Eingangsdatenkanal IN1, ..., IN4 oder zu einem beliebigen Ausgangsdatenkanal OUT1, ..., OUT4 entgegenzunehmen und die angefragte Datenverbindung einzurichten oder nicht einzurichten, wobei der erste Arbiter ARB1 die Einrichtung einer angefragten Datenverbindung niemals dauerhaft verweigert. Wenn ein Schnittstellenprozessor ION1, ..., ION5 eine Anfrage auf Einrichtung einer Datenverbindung stellt und kein Konflikt vorliegt, d.h. nur von einem Schnittstellenprozessor ION1, ..., ION5 eine Anfrage vorliegt, dann richtet der erste Arbiter ARB1 die angefragte Datenverbindung unmittelbar ein. Liegt ein Konflikt vor, d.h. wenn mindestens zwei Anfragen auf Einrichtung einer Datenverbindung von unterschiedlichen Schnittstellenprozessoren ION1, ..., ION5 vorliegen, dann richtet der erste Arbiter ARB1 zuerst die von dem Schnittstellenprozessor ION1, ..., ION5 angefragte Datenverbindung ein, für den die höchste Priorität in der ersten Steuerlogik hinterlegt ist. Nachdem der Schnittstellenprozessor ION1, ..., ION5 mit der höchsten Priorität das Auslesen der Eingangsdaten oder das Hinterlegen der Ausgangsdaten abgeschlossen hat, wird eine Datenverbindung für den Schnittstellenprozessor ION1, ..., ION5 mit der nächsthöheren Priorität, von dem eine Anfrage vorliegt, eingerichtet.

Ein zweiter Arbiter ARB2 ist in die logische Schaltung des FPGAs programmiert, und der zweite Arbiter ARB2 ist ausgestaltet, um mittels eines über einen neunten FPGA-Datenschluss P9 mit dem ersten Datenanschluss DLC1 verbundenen zweiten Multiplexers MUX2 eine Datenverbindung zwischen einem beliebigen Schnittstellenprozessor ION1, ..., ION5 und der ersten Datenverbindung DL1 einzurichten und auf diese Weise einem beliebigen Schnittstellenprozessor ION1, ..., ION5 Zugang zu der ersten Datenverbindung DL1 zu erteilen. Beispielsweise ist in der Abbildung dem zweiten Schnittstellenprozessor ION2 Zugang zu der ersten Datenverbindung DL1 erteilt, sodass der zweite Schnittstellenprozessor ION2 Eingangsdaten aus dem zweiten Eingangsdatenkanal IN2 auslesen, verarbeiten und an eine auf dem ersten Prozessor CN abgearbeitete I/O-Task weiterleiten kann.

Der zweite Arbiter ARB2 weist zudem eine durch den ersten Prozessor CN konfigurierbare zweite Steuerlogik (nicht dargestellt) zur Ansteuerung des zweiten Multiplexers MUX2 auf. Die zweite Steuerlogik ist eingerichtet, um die erste Priorität, die zweite Priorität, die dritte Priorität, die vierte Priorität und die fünfte Priorität vom ersten Prozessor CN aufzunehmen und zu speichern. Der zweite Arbiter ARB2 ist anhand der zweiten Steuerlogik eingerichtet, um von einem beliebigen Schnittstellenprozessor ION1, ..., ION5 eine Anfrage auf Zugang zu der ersten Datenverbindung DL1 entgegenzunehmen und den Zugang zu erteilen oder nicht zu erteilen, wobei der zweite Arbiter ARB2 den Zugang zu der ersten Datenverbindung niemals dauerhaft verweigert. Wenn ein Schnittstellenprozessor ION1, ..., ION5 eine Anfrage auf Zugang zu der ersten Datenverbindung DL1 stellt und kein Konflikt vorliegt, d.h. nur von einem Schnittstellenprozessor ION1, ..., ION5 eine Anfrage vorliegt, dann richtet der zweite Arbiter ARB2 die angefragte Datenverbindung unmittelbar ein. Liegt ein Konflikt vor, d.h. wenn mindestens zwei Anfragen auf Zugang zu der ersten Datenverbindung DL1 von unterschiedlichen Schnittstellenprozessoren ION1, ..., ION5 vorliegen, dann richtet der zweite Arbiter ARB2 zuerst den Zugang für den anfragenden Schnittstellenprozessor ION1, ..., ION5 ein, für den die höchste Priorität in der zweiten Steuerlogik hinterlegt ist. Nachdem der Schnittstellenprozessor ION1, ..., ION5 mit der höchsten Priorität die Weiterleitung der Eingangsdaten an den ersten Prozessor CN abgeschlossen hat, wird eine Zugang zu der ersten Datenverbindung DL1 für den Schnittstellenprozessor ION1, ..., ION5 mit der nächsthöheren Priorität, von dem eine Anfrage vorliegt, eingerichtet.

Die erste Datenverbindung DL1 ist technisch ausgestaltet, um Daten von der Schnittstelleneinheit IU in Richtung des ersten Prozessor CN zu leiten. Die erste Datenverbindung DL1 ist technisch nicht ausgestaltet, um Daten in die umgekehrte Richtung, vom ersten Prozessor CN in Richtung der Schnittstelleneinheit IU, zu leiten. Dementsprechend dient die erste Datenverbindung DL1 ausschließlich der Weiterleitung von Eingangsdaten an den ersten Prozessor CN. Von einer I/O-Task erzeugte Ausgangsdaten werden von dem ersten Prozessor CN mittels der Ausgangsdatenverbindung DLO unter Umgehung des zweiten Arbiters ARB2 auf dem internen Speicher MO hinterlegt. Jeder Schnittstellenprozessor ION1, ..., ION5 ist einrichtbar, um Ausgangsdaten aus dem internen Speicher MO auszulesen und an einen Ausgangsdatenkanal OUT1, ..., OUT4 weiterzuleiten. Auf dem ersten Prozessor CN ist eine Arbitrierungsprogrammroutine hinterlegt. Die Arbitrierungsprogrammroutine ist eingerichtet, um den I/O-Tasks auf Anfrage Zugang zu der Ausgangsdatenverbindung DLO zur Hinterlegung eines Ausgangsdatums in dem internen Speicher MO zu erteilen oder nicht zu erteilen. Wenn von mehr als einer I/O-Task eine Anfrage vorliegt, ist die Arbitrierungsprogrammroutine eingerichtet, den Zugang zu der Ausgangsdatenverbindung DLO zuerst der anfragenden I/O-Task zu erteilen, der die höchste Priorität zugewiesen ist.

Der interne Speicher MO ist in die logische Schaltung des FPGAs integriert und über einen zehnten FPGA-Datenanschluss P10 mit dem Ausgangsdatenanschluss DLC2 verbunden. In einer Ausgestaltung ist der interne Speicher MO als eine Mehrzahl nicht zusammenhängender Adressbereiche ausgestaltet, wobei jedem Schnittstellenprozessor ION1, ..., ION5 ein eigener Adressbereich des internen Speichers MO zugeordnet ist.

Während der Konfigurationsphase des Computersystems HIL weist der erste Prozessor CN jeder I/O-Task des Computerprogramms eine Priorität zu. Die Prioritäten der einzelnen I/O-Tasks sind von einem Anwender des Computersystems HIL mittels einer Konfigurationssoftware auswählbar. Weiterhin werden die Schnittstellenprozessoren ION1, ..., ION5 oder ein Teil der Schnittstellenprozessoren ION1, ..., ION5 den I/O-Tasks zugewiesen, wobei jeder Schnittstellenprozessor ION1, ..., ION5, der einer I/O-Task zugewiesen wird, eindeutig einer einzigen I/O-Task zugewiesen wird. Demnach ist die Anzahl der auf der Schnittstelleneinheit IU hinterlegten Schnittstellenprozessoren ION1, ..., ION5 eine obere Grenze für die Anzahl von I/O-Tasks in dem Computerprogramm. Jede I/O-Task erstellt für jeden der I/O-Task zugewiesenen Schnittstellenprozessor ION1, ..., ION5 genau eine Sequenz von Prozessorbefehlen, wobei jede Sequenz eine Programmroutine zur Weiterleitung und optional zur Verarbeitung von Eingangsdaten oder Ausgangsdaten darstellt. Die Sequenzen werden auf die Schnittstellenprozessoren ION1, ..., ION5 geladen und die Prioritäten der I/O-Tasks werden derart in der ersten Steuerlogik des ersten Arbiters ARB1 und in der zweiten Steuerlogik des zweiten Arbiters ARB2 hinterlegt, das die für einen beliebigen Schnittstellenprozessor ION1, ..., ION5 hinterlegte Priorität gleich der Priorität der I/O-Task ist, der der Schnittstellenprozessor ION1, ..., ION5 zugewiesen ist. Nachdem die Einrichtung der Schnittstelleneinheit IU, d.h. das Laden der Sequenzen auf die Schnittstellenprozessoren ION1, ..., ION5 und die Hinterlegung der Prioritäten in der ersten Steuerlogik und der zweiten Steuerlogik, abgeschlossen ist, werden die Abarbeitung des Computerprogramms durch den ersten Prozessor CN und die Abarbeitung der Sequenzen durch die Schnittstellenprozessoren ION1, ..., ION5 gestartet.

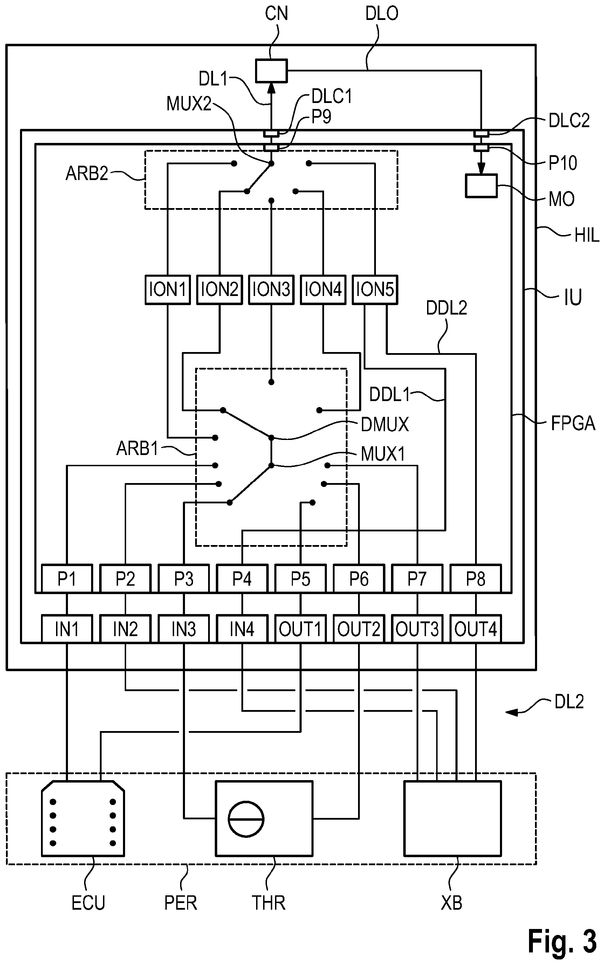

Die Abbildung der Figur 3 zeigt eine zweite bevorzugte Ausführungsform der Erfindung. Im Folgenden werden nur die Unterschiede zu den Abbildungen der vorherigen Figuren erläutert. In dem in der Abbildung skizzierten Ausführungsbeispiel ist von den fünf auf der Schnittstelleneinheit IU hinterlegten Prioritäten die fünfte Priorität am höchsten. Deswegen ist zwischen dem fünften Schnittstellenprozessor ION5 und dem vierten Eingangsdatenkanal IN4 und dem vierten Ausgangsdatenkanal OUT4 jeweils eine den ersten Arbiter ARB1 umgehende direkte Datenverbindung DDL1, DDL2 eingerichtet. Anhand der auf dem fünften Schnittstellenprozessor ION5 hinterlegten Sequenz ist der fünfte Schnittstellenprozessor eingerichtet, um in dem vierten Eingangsdatenkanal IN4 hinterlegte Eingangsdaten auszulesen und an den ersten Prozessor CN weiterzuleiten, und mittels einer direkten Datenverbindung DDL1 ist der fünfte Schnittstellenprozessor ION5 eingerichtet, um die Eingangsdaten aus dem vierten Eingangsdatenkanal IN4 auszulesen, ohne dafür eine Anfrage auf Einrichtung einer Datenverbindung zu dem vierten Eingangsdatenkanal an den ersten Arbiter ARB1 zu senden. Anhand der auf dem fünften Schnittstellenprozessor ION5 hinterlegten Sequenz ist der fünfte Schnittstellenprozessor ION5 weiterhin eingerichtet, um Ausgangsdaten in dem vierten Ausgangsdatenkanal OUT4 zu hinterlegen, und mittels einer weiteren direkten Datenverbindung DDL2 ist der fünfte Schnittstellenprozessor ION5 eingerichtet, um die Ausgangsdaten in dem vierten Ausgangsdatenkanal OUT4 zu hinterlegen, ohne dafür eine Anfrage auf Einrichtung einer Datenverbindung zu dem vierten Ausgangsdatenkanal OUT4 an den ersten Arbiter ARB1 zu senden.

Der vierte Eingangsdatenkanal IN4 und der vierte Ausgangsdatenkanal OUT4 sind dem fünften Schnittstellenprozessor ION5 exklusiv vorbehalten. Der erste Arbiter ARB1 ist nicht ausgestaltet, eine Datenverbindung zwischen einem der vier übrigen Schnittstellenprozessoren ION1, ..., ION4 und dem vierten Eingangsdatenkanal IN4 oder dem vierten Ausgangsdatenkanal OUT4 einzurichten. Der erste Arbiter ARB1 ist auch nicht ausgestaltet, um eine Datenverbindung zwischen dem fünften Schnittstellenprozessor ION5 und einem Eingangsdatenkanal IN1, ..., IN4 oder einem Ausgangsdatenkanal OUT1, ..., OUT4 herzustellen. Für den fünften Schnittstellenprozessor ION5 sind direkte Datenverbindungen DDL1, DDL2 zu allen Eingangsdatenkanälen IN1, ..., IN4 und allen Ausgangsdatenkanälen OUT1, ..., OUT4 eingerichtet, auf die der fünfte Schnittstellenprozessor ION5 bei der Abarbeitung der auf den fünften Schnittstellenprozessor ION5 geladenen Sequenz zugreift.

Die Datenverbindungen zwischen den Schnittstellenprozessoren ION1, ..., ION5 und den Eingangsdatenkanälen IN1, ..., IN4 und den Ausgangsdatenkanälen OUT1, ..., OUT4 sowie der erste Arbiter ARB1 sind in die logische Schaltung des auf der Schnittstelleneinheit IU verbauten FPGAs programmiert. Deshalb sind direkte Datenverbindungen DDL1, DDL2 zwischen Schnittstellenprozessoren ION1, ..., ION5 und Eingangsdatenkanälen IN1, ..., IN4 und Ausgangsdatenkanälen OUT1, ..., OUT4 gemäß den Anforderungen des auf dem ersten Prozessor CN hinterlegten Computerprogramms flexibel einrichtbar, beispielsweise für besonders hoch priorisierte Schnittstellenprozessoren ION1, ..., ION5 oder für Schnittstellenprozessoren ION1, ..., ION5, die ein besonders großes Datenvolumen zu bewältigen haben. Beispielsweise kann auf dem ersten Prozessor eine Einrichtungsroutine hinterlegt sein, die während der Konfigurationsphase automatisch eine logische Schaltung für das auf der Schnittstelleneinheit IU hinterlegte FPGA entwirft, die für jeden Schnittstellenprozessor ION1, ..., ION5, dem die höchstmögliche Priorität zugeordnet ist, direkte Datenverbindungen zu den Eingangsdatenkanälen IN1, ..., IN4 und Ausgangsdatenkanälen OUT1, ..., OUT4 einrichtet, auf die der jeweilige Schnittstellenprozessor ION1, ..., ION5 lesend oder schreibend zugreift.

## Patentansprüche

1. Verfahren zur Verwaltung priorisierter Eingangsdaten in einem Computersystem (HIL),
wobei das Computersystem (HIL) einen ersten Prozessor (CN), eine Schnittstelleneinheit (IU) mit einem ersten Schnittstellenprozessor (ION1) und einem zweiten Schnittstellenprozessor (ION2) und eine erste Datenverbindung (DL1) zwischen dem ersten Prozessor (CN) und der Schnittstelleneinheit (IU) aufweist,
wobei die Schnittstelleneinheit (IU) eingerichtet ist, um in einer Anzahl von Eingangsdatenkanälen (IN1, ..., IN4) der Schnittstelleneinheit (IU) von einer Peripherie (PER) Eingangsdaten aufzunehmen und die Eingangsdaten über die erste Datenverbindung (DL1) an den ersten Prozessor (CN) weiterzuleiten,
wobei eine Peripherie (PER) des Computersystems (HIL) eingerichtet wird, um mittels einer zweiten Datenverbindung (DL2) Eingangsdaten in der Anzahl von Eingangsdatenkanälen (IN1, ..., IN4) zu hinterlegen,
wobei auf dem Computersystem (HIL) ein Computerprogramm hinterlegt wird und eine erste und eine zweite Task des Computerprogramms eingerichtet sind, einen durch die Eingangsdaten definierten Wert einzulesen, um einer Variablen des Computerprogramms einen Wert zuzuweisen und der erste Prozessor (CN) programmiert wird, um das Computerprogramm abzuarbeiten,
wobei der ersten Task eine erste Priorität und der zweiten Task eine zweite Priorität zugewiesen wird,
**dadurch gekennzeichnet, dass** die Schnittstelleneinheit (IU) eine erste Zugriffsverwaltungseinheit (ARB1) aufweist,
der erste Schnittstellenprozessor (ION1) und der zweite Schnittstellenprozessor (ION2) eingerichtet werden, eine Anfrage auf Bereitstellung der in der Anzahl von Eingangsdatenkanälen (IN1, ..., IN4) hinterlegten Eingangsdaten an die erste Zugriffsverwaltungseinheit (ARB1) zu senden,
der erste Schnittstellenprozessor (ION1) eingerichtet wird, Eingangsdaten an die erste Task weiterzuleiten oder Eingangsdaten zu verarbeiten und die verarbeiteten Eingangsdaten an die erste Task weiterzuleiten,
der zweite Schnittstellenprozessor (ION2) eingerichtet wird, Eingangsdaten an die zweite Task weiterzuleiten oder Eingangsdaten zu verarbeiten und die verarbeiteten Eingangsdaten an die zweite Task weiterzuleiten,
und die erste Priorität und die zweite Priorität auf der ersten Zugriffsverwaltungseinheit (ARB1) hinterlegt werden,
wobei die erste Zugriffsverwaltungseinheit (ARB1) eingerichtet ist, während der Abarbeitung des Computerprogramms die in der Anzahl von Eingangsdatenkanälen (IN1, ..., IN4) hinterlegten Eingangsdaten dem ersten Schnittstellenprozessor (ION1) und dem zweiten Schnittstellenprozessor (ION2) auf Anfrage bereitzustellen oder nicht bereitzustellen,
und die Eingangsdaten zuerst dem ersten Schnittstellenprozessor (ION1) bereitzustellen, wenn sowohl vom ersten Schnittstellenprozessor (ION1) als auch vom zweiten Schnittstellenprozessor (ION2) eine Anfrage auf Bereitstellung der in der Anzahl von Eingangsdatenkanälen (IN1, ..., IN4) hinterlegten Eingangsdaten vorliegt und die erste Priorität höher als die zweite Priorität ist.

2. Verfahren nach einem der vorhergehenden Ansprüche, wobei das Computersystem (HIL) eingerichtet ist, um das Computerprogramm in harter Echtzeit abzuarbeiten, insbesondere wobei das Computersystem (HIL) als Hardware-in-the-Loop-Simulator oder als Rapid-Control-Prototyping-Plattform ausgestaltet ist.

3. Verfahren nach einem der vorhergehenden Ansprüche, wobei die Schnittstelleneinheit (IU) eine zweite Zugriffsverwaltungseinheit (ARB2) aufweist,
der erste Schnittstellenprozessor (ION1) und der zweite Schnittstellenprozessor (ION2) eingerichtet werden, eine Anfrage auf Zugang zu der ersten Datenverbindung (DL1) an die zweite Zugriffsverwaltungseinheit (ARB2) zu senden,
die zweite Zugriffsverwaltungseinheit (ARB2) eingerichtet ist, um dem ersten Schnittstellenprozessor (ION1) und dem zweiten Schnittstellenprozessor (ION2) während der Abarbeitung des Computerprogramms den Zugang zu der ersten Datenverbindung (DL1) auf Anfrage zu erteilen oder nicht zu erteilen
und den Zugang zu der ersten Datenverbindung (DL1) zuerst dem ersten Schnittstellenprozessor (ION1) zu erteilen, wenn sowohl vom ersten Schnittstellenprozessor (ION1) als auch vom zweiten Schnittstellenprozessor (ION2) eine Anfrage auf Zugang zu der ersten Datenverbindung (DL1) vorliegt und die erste Priorität höher als die zweite Priorität ist.

4. Verfahren nach einem der vorhergehenden Ansprüche, wobei vor Beginn der Abarbeitung des Computerprogramms durch den ersten Prozessor (CN) eine Konfigurationsphase des Computersystems (HIL) gestartet wird und das Computersystem (HIL), insbesondere der erste Prozessor (CN), während der Konfigurationsphase den ersten Schnittstellenprozessor (ION1) und den zweiten Schnittstellenprozessor (ION2) einrichtet und die erste Priorität und die zweite Priorität auf der ersten Zugriffsverwaltungseinheit (ARB1), insbesondere auf der ersten Zugriffsverwaltungseinheit (ARB1) und der zweiten Zugriffsverwaltungseinheit (ARB2), hinterlegt.

5. Verfahren nach einem der vorhergehenden Ansprüche, wobei die Schnittstelleneinheit (IU) mehr als zwei Schnittstellenprozessoren (ION1, ..., ION5) aufweist, wobei jeder Schnittstellenprozessor (ION1, ..., ION5) entweder einer Task des Computerprogramms eindeutig zugeordnet wird oder keiner Task des Computerprogramms zugeordnet wird, wobei jeder Schnittstellenprozessor einrichtbar ist, eine Anfrage auf Bereitstellung der in der Anzahl von Eingangsdatenkanälen (IN1, ..., IN4) hinterlegten Eingangsdaten zu stellen, wobei für jeden einer Task zugeordneten Schnittstellenprozessor (ION1, ..., ION5) eine Priorität hinterlegt wird.

6. Verfahren nach Anspruch 5, wobei die Schnittstelleneinheit (IU) einen Ausgangsdatenkanal (OUT1) zur Hinterlegung von Ausgangsdaten zum Auslesen durch die Peripherie (PER) aufweist
und ein dritter Schnittstellenprozessor (ION3) eingerichtet wird, um von dem Computerprogramm erzeugte Ausgangsdaten in dem Ausgangsdatenkanal (OUT1) zu hinterlegen,
wobei zwischen dem dritten Schnittstellenprozessor (OUT3) und dem ersten Prozessor (CN) eine die zweite Zugriffsverwaltungseinheit (ARB2) umgehende erste direkte Datenverbindung eingerichtet wird.

7. Verfahren nach einem der vorhergehenden Ansprüche, wobei die Schnittstelleneinheit mehr als zwei Schnittstellenprozessoren (ION1, ..., ION5) aufweist und zwischen einem Schnittstellenprozessor (ION5) und einem Eingangsdatenkanal (IN4) eine die erste Zugriffsverwaltungseinheit (ARB1) umgehende zweite direkte Datenverbindung (DDL1) eingerichtet wird.

8. Verfahren nach einem der Ansprüche 4 bis 7, wobei die Schnittstellenprozessoren (ION1, ..., ION4) während der Konfigurationsphase als Softcore-Prozessoren auf einem FPGA implementiert werden, insbesondere wobei die Softcore-Prozessoren als Flow-Control-Prozessoren ausgestaltet werden.

9. Schnittstelleneinheit (IU) für den Datenaustausch zwischen einem ersten Prozessor (CN) eines Computersystems (HIL) und einer Peripherie (PER) des Computersystems (HIL),
wobei die Schnittstelleneinheit (IU) einen Datenanschluss (DLC) für eine Anbindung der Schnittstelleneinheit (IU) an eine erste Datenverbindung (DL1) des Computersystems (HIL) aufweist, wobei mittels der ersten Datenverbindung (DL1) Daten von der Schnittstelleneinheit (IU) zu dem ersten Prozessor (CN) übertragbar sind,
wobei die Schnittstelleneinheit (IU) eine Anzahl von Eingangsdatenkanälen (IN1, ..., IN4) zur Aufnahme von durch die Peripherie (PER) mittels einer zweiten Datenverbindung (DL2) in den Eingangsdatenkanälen (IN1, ..., IN1) hinterlegten Eingangsdaten aufweist,
**dadurch gekennzeichnet, dass** die Schnittstelleneinheit (IU) eine erste Zugriffsverwaltungseinheit (ARB1) aufweist,
die erste Zugriffsverwaltungseinheit (ARB1) eingerichtet ist, um von einem auf der Schnittstelleneinheit (IU) hinterlegten und für die Weiterleitung von Eingangsdaten an eine erste Task eines von dem ersten Prozessor (CN) abgearbeiteten Computerprogramms oder für die Verarbeitung von Eingangsdaten und die Weiterleitung der verarbeiteten Eingangsdaten an eine erste Task des Computerprogramms eingerichteten ersten Schnittstellenprozessor (ION1) eine Anfrage auf Bereitstellung der in den Eingangsdatenkanälen (IN1, ..., IN4) hinterlegten Eingangsdaten zu empfangen,
die erste Zugriffsverwaltungseinheit (ARB2) eingerichtet ist, um von einem auf der Schnittstelleneinheit (IU) hinterlegten und für die Weiterleitung von Eingangsdaten an eine zweite Task des Computerprogramms oder für die Verarbeitung von Eingangsdaten und die Weiterleitung der verarbeiteten Eingangsdaten an eine zweite Task des Computerprogramms eingerichteten zweiten Schnittstellenprozessor (ION2) eine Anfrage auf Bereitstellung der in der Anzahl von Eingangsdatenkanälen (IN1, ..., IN4) hinterlegten Eingangsdaten zu empfangen
und dem ersten Schnittstellenprozessor (ION1) und dem zweiten Schnittstellenprozessor (ION2) die in der Anzahl von Eingangsdatenkanälen (IN1, ..., IN4) hinterlegten Eingangsdaten auf Anfrage bereitzustellen oder nicht bereitzustellen,
auf der ersten Zugriffsverwaltungseinheit (ARB1) eine der ersten Task zugewiesene erste Priorität und eine der zweiten Task zugewiesene zweite Priorität hinterlegbar sind,
und die erste Zugriffsverwaltungseinheit (ARB1) eingerichtet ist, um die in der Anzahl von Eingangsdatenkanälen (IN1, ..., IN4) hinterlegten Eingangsdaten zuerst dem ersten Schnittstellenprozessor (ION1) bereitzustellen, wenn sowohl vom ersten Schnittstellenprozessor (IN1) als auch vom zweiten Schnittstellenprozessor (IN2) eine Anfrage auf Bereitstellung der in der Anzahl von Eingangsdatenkanälen (IN1, ..., IN4) hinterlegten Eingangsdaten vorliegt und die erste Priorität höher als die zweite Priorität ist.

10. Schnittstelleneinheit (IU) nach Anspruch9, wobei die Schnittstelleneinheit (IU) als austauschbare Schnittstelleneinheit, insbesondere als steckbare I/O-Karte, ausgestaltet ist.

11. Schnittstelleneinheit (IU) nach einem der Ansprüche 9 oder 10, wobei die Schnittstelleneinheit (IU) ausgestaltet und vorgesehen ist, in einem Computersystem (HIL) zur Abarbeitung eines Computerprogramms in harter Echtzeit verbaut zu werden, insbesondere in einem Hardware-in-the-Loop-Simulator oder in einer Rapid-Control-Prototyping-Plattform verbaut zu werden.

12. Schnittstelleneinheit (IU) nach einem der Ansprüche 9 bis 11, wobei die Schnittstelleneinheit (IU) eine zweite Zugriffsverwaltungseinheit (ARB2) aufweist, auf der zweiten Zugriffsverwaltungseinheit (ARB2) die erste Priorität und die zweite Priorität hinterlegbar sind und die zweite Zugriffsverwaltungseinheit (ARB2) eingerichtet ist, um vom ersten Schnittstellenprozessor (ION1) und vom zweiten Schnittstellenprozessor (ION2) eine Anfrage auf Zugang zu der ersten Datenverbindung (DL1) entgegenzunehmen und den Zugang zu erteilen oder nicht zu erteilen,
und den Zugang zu der ersten Datenverbindung (DL1) zuerst dem ersten Schnittstellenprozessor (ION1) zu erteilen, wenn sowohl vom ersten Schnittstellenprozessor (ION1) als auch vom zweiten Schnittstellenprozessor (ION2) eine Anfrage auf Zugang zu der ersten Datenverbindung (DL1) vorliegt und die erste Priorität höher als die zweite Priorität ist.

13. Schnittstelleneinheit (IU) nach einem der Ansprüche 9 bis 12, wobei die Schnittstelleneinheit (IU) ein durch das Computersystem (HIL) programmierbares FPGA aufweist und das FPGA für die Hinterlegung des ersten Schnittstellenprozessors (ION1) und des zweiten Schnittstellenprozessors (ION2) in Form von Softcore-Prozessoren eingerichtet ist.

14. Schnittstelleneinheit (IU) nach einem der Ansprüche 9 bis 13, wobei die erste Zugriffsverwaltungseinheit (ARB1) eingerichtet ist, um dem ersten Schnittstellenprozessor (ION1) und dem zweiten Schnittstellenprozessor (ION2) die in einem beliebigen Eingangsdatenkanal (IN1, ..., IN4) hinterlegten Eingangsdaten bereitzustellen.

## Claims

1. A method for administering prioritized input data in a computer system (HIL),
the computer system comprising a first processor (CN), an interface unit (IU) having a first interface processor (ION1) and a second interface processor (ION2), and a first data link (DL1) between the first processor (CN) and the interface unit (IU),
the interface unit (IU) being set up for receiving input data from a periphery (PER) in a plurality of input data channels (IN1, ..., IN4) of the interface unit (IU) and for forwarding the input data to the first processor (CN) by means of the first data link (DL1),
a periphery (PER) of the computer system (HIL) being set up for storing input data in the plurality of input data channels (IN1, ..., IN4) by means of a second data link (DL2),
a computer program being stored on the computer system (HIL) and a first and a second task of the computer program being set up for reading a value defined by the input data in order to assign a value to a variable of the computer program, and the first processor (CN) being programmed for executing the computer program,
the first task being assigned a first priority and the second task being assigned a second priority,
**characterized in that** the interface unit (IU) comprises a first access rights control unit (ARB1),
the first interface processor (ION1) and the second interface processor (ION2) are set up for sending to the first access rights control unit (ARB1) a request for providing the input data stored in the plurality of input data channels (IN1, ..., IN4),
the first interface processor (ION1) is set up for forwarding input data to the first task or for processing input data and forwarding the processed input data to the first task,
the second interface processor (ION2) is set up for forwarding input data to the second task or for processing input data and forwarding the processed input data to the second task,
and the first priority and the second priority are stored in the first access rights control unit (ARB1),
wherein the first access rights control unit (ARB1) is set up for providing or not providing, on request, the input data saved in the plurality of input data channels (IN1, ..., IN4) to the first interface processor (ION1) and the second interface processor (ION2) during processing of the computer program,
and for firstly providing the input data to the first interface processor (ION1) in case a request to provide the input data stored in the plurality of input data channels (IN1, ..., IN4) is present both from the first interface processor (ION1) and from the second interface processor (ION2), and the first priority is higher than the second priority.

2. The method according to any one of the preceding claims, **characterized in that** the computer system (HIL) is set up for running the computer program in hard real time, particularly **in that** the computer system (HIL) is implemented as a hardware-in-the-loop simulator or as a rapid control prototyping platform.

3. The method according to any one of the preceding claims, **characterized in that** the interface unit (IU) comprises a second access rights control unit (ARB2),
the first interface processor (ION1) and the second interface processor (ION2) are set up for sending to the second access rights control unit (ARB2) a request for access to the first data link (DL1),
the second access rights control unit (ARB2) is set up for providing or not providing access to the first data link (DL1) for the first interface processor (ION1) and the second interface processor (ION2) upon request during running of the computer program
and for firstly providing access to the first data link (DL1) for the first interface processor (ION1) in case a request for access to the first data link (DL1) is present both from the first interface processor (ION1) and from the second interface processor (ION2) and the first priority is higher than the second priority.

4. The method according to any one of the preceding claims, **characterized in that** prior to the first processor (CN) running the computer program, a configuration phase of the computer system (HIL) is started and the computer system (HIL), particularly the first processor (CN), sets up the first interface processor (ION1) and the second interface processor (ION2) during the configuration phase and stores the first priority and the second priority in the first access rights control unit (ARB1), particularly in the first access rights control unit (ARB1) and the second access rights control unit (ARB2).

5. The method according to any one of the preceding claims, **characterized in that** the interface unit (IU) comprises more than two interface processors (ION 1, ..., ION5), wherein each interface processor (ION 1, ..., ION5) either is uniquely associated with one task of the computer program or is associated with no task of the computer program, wherein each interface processor (ION 1, ..., ION5) can be set up for placing a request for providing the input data stored in the plurality of input data channels (IN1, ..., IN4), wherein a priority is stored for each interface processor (ION 1, ..., ION5) associated with a task.

6. The method according to claim 5, **characterized in that** the interface unit (IU) comprises an output data channel (OUT1) for storing output data for being read by the periphery (PER)
and a third interface processor (ION3) is set up for storing output data generated by the computer program in the output data channel (OUT1),
wherein a first direct data link bypassing the second access rights control unit (ARB2) is set up between the third interface processor (OUT3) and the first processor (CN).

7. The method according to any one of the preceding claims, **characterized in that** the interface unit comprises more than two interface processors (ION1, ..., ION5) and a second direct data link (DDL1) bypassing the first access rights control unit (ARB1) is set up between an interface processor (ION5) and an input data channel (IN4).

8. The method according to any one of the claims 4 through 7, **characterized in that** the interface processors (ION1, ..., ION4) are implemented as softcore processors on an FPGA during the configuration phase, particularly wherein the softcore processors are implemented as flow control processors.

9. An interface unit (IU) for exchanging data between a first processor (CN) of a computer system (HIL) and a periphery (PER) of the computer system (HIL),
the interface unit (IU) comprising a data interface (DLC) for connecting the interface unit (IU) to a first data link (DL1) of the computer system (HIL), data being transferable from the interface unit (IU) to the first processor (CN) by means of the first data link (DL1),
the interface unit (IU) comprising a plurality of input data channels (IN1, ..., IN4) for receiving input data stored in the input data channels (IN1, ..., IN4) by the periphery (PER) by means of a second data link (DL2),
**characterized in that** the interface unit (IU) comprises a first access rights control unit (ARB1),
the first access rights control unit (ARB1) is set up for receiving a request for providing the input data stored in the input data channels (IN1, ..., IN4) from a first interface processor (ION1) stored on the interface unit (IU) and set up for forwarding input data to a first task of a computer program being run by the first processor (CN) or for processing input data and forwarding the processed input data to a first task of the computer program,
the first access rights control unit (ARB2) is set up for receiving a request for providing the input data stored in the plurality of input data channels (IN1, ..., IN4) from a second interface processor (ION2) stored on the interface unit (IU) and set up for forwarding input data to a second task of the computer program or for processing input data and forwarding the processed input data to a second task of the computer program
and for providing or not providing, on request, the input data saved in the plurality of input data channels (IN1, ..., IN4) to the first interface processor (ION1) and the second interface processor (ION2),
a first priority assigned to the first task and a second priority assigned to the second task are able to be stored in the first access rights control unit (ARB1),
and the first access rights control unit (ARB1) is set up for firstly providing the input data stored in the plurality of input data channels (IN1, ..., IN4) to the first interface processor (ION1) in case a request to provide the input data stored in the plurality of input data channels (IN1, ..., IN4) is present both from the first interface processor (ION1) and from the second interface processor (ION2), and the first priority is higher than the second priority.

10. The interface unit (IU) according to claim 9, **characterized in that** the interface unit (IU) is implemented as an interchangeable interface unit, particularly as a plug-in I/O card.

11. The interface unit (IU) according to any one of the claims 9 or 10, **characterized in that** the interface unit (IU) is implemented for being installed in a computer system (HIL) for running a computer program in hard real time, particularly in a hardware-in-the-loop simulator or a rapid control prototyping platform.

12. The interface unit (IU) according to any one of the claims 9 through 11, **characterized in that** in the interface unit (IU) comprises a second access rights control unit (ARB2), the first priority and the second priority can be stored in the second access rights control unit (ARB2), and the second access rights control unit (ARB2) is set up for receiving a request for access to the first data link (DL1) from the first interface processor (ION1) and the second interface processor (ION2) and for providing or not providing the access,
and for firstly providing access to the first data link (DL1) for the first interface processor (ION1) in case a request for access to the first data link (DL1) is present both from the first interface processor (ION1) and from the second interface processor (ION2) and the first priority is higher than the second priority.

13. The interface unit (IU) according to any one of the claims 9 through 12, **characterized in that** the interface unit (IU) comprises an FPGA programmable by the computer system (HIL) and the FPGA is set up for storing the first interface processor (ION1) and the second interface processor (ION2) in the form of softcore processors.

14. The interface unit (IU) according to any one of the claims 9 through 13, **characterized in that** the first access rights control unit (ARB1) is set up for providing input data stored in any arbitrary input data channel (IN1, ..., IN4) to the first interface processor (ION1) and the second interface processor (ION2).

## Revendications

1. Procédé pour gérer des données d'entrée priorisées dans un système d'ordinateur (HIL),
dans lequel le système d'ordinateur (HIL) comporte un premier processeur (CN), une unité d'interface (IU) avec un premier processeur d'interface (ION1) et un second processeur d'interface (ION2) et une première connexion de données (DU) entre le premier processeur (CN) et l'unité d'interface (IU),
dans lequel l'unité d'interface (IU) est configurée pour stocker des données d'entrée depuis une périphérie (PER) dans une multitude de voies de données d'entrée (IN1, ..., IN4) de l'unité d'interface (IU) et retransmettre les données d'entrée au premier processeur (CN) via la première connexion de données (DU),
dans lequel une périphérie (PER) du système d'ordinateur (HIL) est configurée pour, à l'aide d'une seconde connexion de données (DL2), stocker des données d'entrée dans la multitude de voies de données d'entrée (IN1, ..., IN4),
sachant qu'un programme informatique est stocké sur le système d'ordinateur (HIL) et une première et une seconde tâches du programme informatique sont configurées pour lire une valeur définie par les données d'entrée, pour attribuer une valeur à une variable du programme informatique et le premier processeur (CN) est programmé pour exécuter le programme informatique,
dans lequel une première priorité est attribuée à la première tâche et une seconde priorité est attribuée à la seconde tâche,
**caractérisé en ce que** l'unité d'interface (IU) comporte une première unité de gestion d'accès (ARB1),
le premier processeur d'interface (ION1) et le second processeur d'interface (ION2) sont configurés pour envoyer à la première unité de gestion d'accès (ARB1) une demande de mise à disposition des données d'entrée stockées dans la multitude de voies de données d'entrée (IN1, ..., IN4),
le premier processeur d'interface (ION1) est configuré pour retransmettre des données d'entrée à la première tâche ou traiter des données d'entrée et retransmettre les données d'entrée traitées à la première tâche,
le second processeur d'interface (ION2) est configuré pour retransmettre des données d'entrée à la seconde tâche ou traiter des données d'entrée et retransmettre les données d'entrée traitées à la seconde tâche,
et la première priorité et la seconde priorité sont stockées sur la première unité de gestion d'accès (ARB1),
dans lequel la première unité de gestion d'accès (ARB1) est configurée pour, durant l'exécution du programme informatique, mettre à la disposition ou ne pas mettre à la disposition du premier processeur d'interface (ION1) et du second processeur d'interface (ION2), sur demande, les données d'entrée stockées dans la multitude de voies de données d'entrée (IN1, ..., IN4),
et mettre les données d'entrée d'abord à la disposition du premier processeur d'interface (ION1) si une demande de mise à disposition des données stockées dans la multitude de voies de données d'entrée (IN1, ..., IN4) est présente aussi bien depuis le premier processeur d'interface (ION1) que depuis le second processeur d'interface (ION2) et la première priorité est plus élevée que la seconde priorité.

2. Procédé selon l'une des revendications précédentes, dans lequel le système d'ordinateur (HIL) est configuré pour exécuter le programme informatique en temps réel strict, en particulier, dans lequel le système d'ordinateur (HIL) se présente sous la forme d'un simulateur « matériel dans la boucle » ou d'une plateforme de type « Rapid Control Prototyping ».

3. Procédé selon l'une des revendications précédentes, dans lequel l'unité d'interface (IU) comporte une seconde unité de gestion d'accès (ARB2),
le premier processeur d'interface (ION1) et le second processeur d'interface (ION2) sont configurés pour envoyer à la seconde unité de gestion d'accès (ARB2) une demande d'accès à la première connexion de données (DU),
la seconde unité de gestion d'accès (ARB2) est configurée pour, durant l'exécution du programme informatique, accorder ou ne pas accorder sur demande au premier processeur d'interface (ION1) et au second processeur d'interface (ION2) l'accès à la première connexion de données (DU)
et accorder l'accès à la première connexion de données (DU) d'abord au premier processeur d'interface (ION1) si une demande d'accès à la première connexion de données (DU) est présente est présente aussi bien depuis le premier processeur d'interface (ION1) que depuis le second processeur d'interface (ION2) et la première priorité est plus élevée que la seconde priorité.

4. Procédé selon l'une des revendications précédentes, dans lequel avant le début de l'exécution du programme informatique par le premier processeur (CN), une phase de configuration du système d'ordinateur (HIL) est démarrée et le système d'ordinateur (HIL), en particulier le premier processeur (CN), configure durant la phase de configuration le premier processeur d'interface (ION1) et le second processeur d'interface (ION2) et la première priorité et la seconde priorité sur la première unité de gestion d'accès (ARB1), en particulier les stockent sur la première unité de gestion d'accès (ARB1) et sur la seconde unité de gestion d'accès (ARB2).

5. Procédé selon l'une des revendications précédentes, dans lequel l'unité d'interface (IU) comporte plus de deux processeurs d'interface (ION1, ..., ION5), sachant que chaque processeur d'interface (ION1, ..., ION5) est soit attribué de manière univoque à une tâche du programme informatique soit n'est attribué à aucune tâche du programme informatique, sachant que chaque processeur d'interface est configurable pour émettre une demande de mise à disposition des données d'entrée stockées dans la multitude de voies de données d'entrée (IN1, ..., IN4), sachant qu'une priorité est stockée pour chacun des processeurs d'interface (ION1, ..., ION5) attribué à une tâche.

6. Procédé selon la revendication 5, dans lequel l'unité d'interface (IU) comporte une voie de données de sortie (OUT1) pour stocker des données de sortie pour la lecture par la périphérie (PER)
et un troisième processeur d'interface (ION3) est configuré pour stocker les données de sortie générées par le programme informatique dans la voie de données de sortie (OUT1),
sachant qu'une première connexion de données directe contournant la seconde unité de gestion d'accès (ARB2) est configurée entre le troisième processeur d'interface (OUT3) et le premier processeur (CN).

7. Procédé selon l'une des revendications précédentes, dans lequel l'unité d'interface comporte plus de deux processeurs d'interface (ION1, .... ION5) et une seconde connexion de données directe (DDL1) contournant la première unité de gestion d'accès (ARB1) est configurée entre un processeur d'interface (ION5) et une voie de données d'entrée (IN4).

8. Procédé selon l'une des revendications 4 à 7, dans lequel les processeurs d'interface (ION1, ..., ION4) sont réalisés sous forme de coeurs de processeur logiciels sur un réseau de portes programmables (FPGA) durant la phase de configuration, en particulier, dans lequel les coeurs de processeur logiciels se présentent sous la forme de processeurs de régulation de flux.

9. Unité d'interface (IU) pour l'échange de données entre un premier processeur (CN) d'un système d'ordinateur (HIL) et une périphérie (PER) du système d'ordinateur (HIL),
dans laquelle l'unité d'interface (IU) comporte une prise de données (DLC) pour une connexion de l'unité d'interface (IU) a une première connexion de données (DU) du système d'ordinateur (HIL), sachant qu'à l'aide la première connexion de données (DU), des données peuvent être transmises de l'unité d'interface (IU) au premier processeur (CN),
dans laquelle l'unité d'interface (IU) comporte une multitude de voies de données d'entrée (IN1, ..., IN4) pour recevoir des données d'entrées stockées par la périphérie (PER) dans les voies de données d'entrée (IN1, ..., IN4) au moyen d'une seconde connexion de données (DL2),
**caractérisé en ce que** l'unité d'interface (IU) comporte une première unité de gestion d'accès (ARB1),
la première unité de gestion d'accès (ARB1) est configurée pour recevoir depuis un premier processeur d'interface (ION1) disposé sur l'unité d'interface (IU) et configuré pour la retransmission de données d'entrée à une première tâche d'un programme informatique exécuté par le premier processeur (CN) ou pour le traitement de données d'entrée et la retransmission des données d'entrée traitées à une première tâche du programme informatique, une demande de mise à disposition des données d'entrées stockées dans les voies de données d'entrée (IN1, ..., IN4),
la première unité de gestion d'accès (ARB2) est configurée pour recevoir depuis un second processeur d'interface (ION2) disposé sur l'unité d'interface (IU) et configuré pour la retransmission de données d'entrée à une seconde tâche du programme informatique ou pour le traitement de données d'entrée et la retransmission des données d'entrée traitées à une seconde tâche du programme informatique, une demande de mise à disposition des données d'entrées stockées dans la multitude de voies de données d'entrée (IN1, ..., IN4)
et mettre à la disposition, sur demande, ou ne pas mettre à la disposition du premier processeur d'interface (ION1) et du second processeur d'interface (ION2) les données d'entrées stockées dans la multitude de voies de données d'entrée (IN1, ..., IN4),
une première priorité attribuée à la première tâche et une seconde priorité attribuée à la seconde tâche peuvent être stockées sur la première unité de gestion d'accès (ARB1),
et la première unité de gestion d'accès (ARB1) est configurée pour mettre les données d'entrée stockées dans la multitude de voies de données d'entrée (IN1, ..., IN4) d'abord à la disposition du premier processeur d'interface (ION1) si une demande de mise à disposition des données stockées dans la multitude de voies de données d'entrée (IN1, ..., IN4) est présente aussi bien depuis le premier processeur d'interface (IN1) que depuis le second processeur d'interface (IN2) et la première priorité est plus élevée que la seconde priorité.

10. Unité d'interface (IU) selon la revendication 9, dans laquelle l'unité d'interface (IU) se présente sous la forme d'une unité d'interface remplaçable, en particulier sous la forme d'une carte E/S enfichable.

11. Unité d'interface (IU) selon l'une des revendications 9 ou 10, dans laquelle l'unité d'interface (IU) se présente sous une forme et est prévue pour être incorporée dans un système d'ordinateur (HIL) pour l'exécution d'un programme informatique en temps réel strict, en particulier dans un simulateur de type matériel-dans-la-boucle ou dans une plateforme de type « Rapid Control Prototyping ».

12. Unité d'interface (IU) selon l'une des revendications 9 à 11, dans laquelle l'unité d'interface (IU) comporte une seconde unité de gestion d'accès (ARB2), la première priorité et la seconde priorité peuvent être stockées sur la seconde unité de gestion d'accès (ARB2) et la seconde unité de gestion d'accès (ARB2) est configurée pour recevoir du premier processeur d'interface (ION1) et du second processeur d'interface (ION2) une demande d'accès à la première connexion de données (DU) et accorder l'accès ou ne pas accorder l'accès,
et accorder l'accès à la première connexion de données (DU) d'abord au premier processeur d'interface (ION1) si une demande d'accès à la première connexion de données (DU) est présente est présente aussi bien depuis le premier processeur d'interface (ION1) que depuis le second processeur d'interface (ION2) et la première priorité est plus élevée que la seconde priorité.

13. Unité d'interface (IU) selon l'une des revendications 9 à 12, dans laquelle l'unité d'interface (IU) comporte un réseau de portes programmables (FPGA) programmable par le système d'ordinateur (HIL) et le réseau de portes programmables (FPGA) est configuré pour le stockage du premier processeur d'interface (ION1) et du second processeur d'interface (ION2) sous forme de coeurs de processeur logiciels.

14. Unité d'interface (IU) selon l'une des revendications 9 à 13, dans laquelle la première unité de gestion d'accès (ARB1) est configurée pour mettre à la disposition du premier processeur d'interface (ION1) et du second processeur d'interface (ION 2) les données d'entrée stockées dans une voie de données d'entrée (IN1, ..., IN4) quelconque
